(19) Europäisches Patentamt
European Patent Office
Office européen des brevets

(11) **EP 2 950 134 A1**

(12) # EUROPEAN PATENT APPLICATION

(43) Date of publication:
**02.12.2015 Bulletin 2015/49**

(21) Application number: **14199088.7**

(22) Date of filing: **19.12.2014**

(51) Int Cl.:
**G02B 27/09** (2006.01)    **F21V 5/04** (2006.01)
**F21V 7/00** (2006.01)    **H01L 33/54** (2010.01)
**H01L 33/58** (2010.01)    **G02B 19/00** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.05.2014 CN 201410240806**

(71) Applicant: **Self Electronics Co., Ltd.
Ningbo 315103 (CN)**

(72) Inventors:
- **Zhang, Fawei
Ningbo 31513 (CN)**
- **He, Zupin
Ningbo 31513 (CN)**

(74) Representative: **2K Patentanwälte Blasberg
Kewitz & Reichel
Partnerschaft mbB
Schumannstrasse 27
60325 Frankfurt am Main (DE)**

(54) **Led lens and illumination system for led lamp**

(57)    An illumination system for LED lamp includes at least one LED lens, and at least one illumination area arranged in lighting direction of the LED lens. The LED lens includes an optical axis, a first light emitting surface, a second light emitting surface which only has one intersecting line with the first light emitting surface, a light source recess, and a critical reflection surface. An emergent light of the first light emitting surface is separated from that of the second light emitting surface. Since the emergent light of the first light emitting surface is separated from that of the second light emitting surface, the light emitted from the first, second light emitting surfaces illuminate towards the direction which is far away from the optical axis. Therefore, the illumination system for LED lamp not only light up two rows of goods but also it has no light glaring people's eyes.

FIG. 4

**Description**

RELATED APPLICATION

The present application claims benefit of the Chinese Application, CN201410240806.8, filed on May 30, 2014.

BACKGROUND

1. TECHNICAL FIELD

The present application relates to lighting devices, and more particularly to an LED lens and an illumination system for LED lamp.

2. DESCRIPTION OF THE RELATED ART

For years, people have used traditional incandescent or fluorescence lighting apparatus in order to address their interior lighting concerns. However, such lighting apparatuses present a number of drawbacks. For example, the popular halogen apparatus presents the following drawbacks, such as relatively high power consumption, inefficiency of light dispersion due to the placement of its metal shield in the line sight of the halogen bulb, and its limited effectiveness in preventing glare from the halogen bulb.

Recently, a number of LED lighting apparatuses have been designed to replace the halogen apparatus, as well as other traditional incandescent or fluorescence lighting apparatuses. Especially, the LED lighting apparatuses are used in the super market, exhibition hall, museum, and so on because of long-life and energy-saving thereof. In these situations, especially storage rack of the super market, the LED light apparatuses must light up two rows of goods. At the same time, it cannot glare eyes of the customers when they select goods or browse through the market.

The above information disclosed in this section is only for enhancement of understanding of the background of the invention and therefore it may contain information that does not form the prior art that is already known in this country to a person of ordinary skill in the art.

SUMMARY OF INVENTION

It is an object of the present invention to provide an enhanced LED lens and illumination system for LED lamp, particularly one that is suited for overcoming at least some of the afore-mentioned drawbacks.

This problem is solved by an LED lens and illumination system for LED lamp according to claim 1. Further advantageous embodiments are the subject-matter of the dependent claims.

An LED lens includes an optical axis, a first light emitting surface, a second light emitting surface which only has one intersecting line with the first light emitting surface, a light source recess arranged through the optical axis, and a critical reflection surface disposed between the first, second light emitting surfaces and the light source recess. The intersecting line is perpendicularly intersect with the optical axis. The first, second light emitting surfaces receive the light emitted from the light source recess and the critical reflection surface and directly emit the receiving light. An emergent light of the first light emitting surface is separated from that of the second light emitting surface.

A LED lens includes an optical axis, a V-shaped groove, a light source recess arranged through the optical axis, and a critical reflection surface arranged between the V-shaped groove and the light source recess. Two sides of the V-shaped groove is symmetrical with the optical axis as the axis of symmetry. The two sides of the V-shaped groove receive the light emitted from the light source recess and the critical reflection surface and directly emit the received light. An emergent light of one side of the V-shaped groove is separated from that of another.

An illumination system for LED lamp includes at least one LED lens described above, and at least one illumination area arranged in lighting direction of the LED lens. The positional relationship between the LED lens and the illumination area is limited in following formula:

$$tga = x/h$$

wherein: a is half of beam angle of the LED lens;
x is a distance between the illumination area and the optical axis of the LED lens;
h is a minimum distance between the illumination area (20) and the LED lens.

In use, since the LED lens has the first, second light emitting surfaces and the emergent light of the first light emitting surface is separated from that of the second light emitting surface, the light emitted from the first, second light emitting surfaces illuminate towards the direction which is far away from the optical axis. Moreover, when people browse the goods on the storage rack, they will locate in a non-illumination area, such as aisle, in which it has no light. Therefore, the illumination system for LED lamp not only light up two rows of goods but also it has no light glaring people's eyes.

BRIEF DESCRIPTION OF THE DRAWINGS

Many aspects of the embodiments can be better understood with references to the following drawings. The components in the drawings are not necessarily drawn to scale, the emphasis instead being placed upon clearly illustrating the principles of the embodiments. Moreover, in the drawings, like reference numerals designate corresponding parts throughout five views.

FIG. 1 is a light path view of an illumination system for LED lamp in accordance with one embodiment of the disclosure.

FIG. 2 is an isometric view of an LED lens of the illumination system for LED lamp of FIG. 1.

FIG. 3 is a cross section view of the LED lens of FIG. 2.

FIG. 4 is a light path view of the LED lens of FIG. 2.

FIG. 5 is an isometric view of another LED lens of the illumination system for LED lamp in accordance with one embodiment of the disclosure.

DETAILED DESCRIPTION

The present invention is illustrated by way of example and not by way of limitation in the figures of the accompanying drawings. It should be noted that references to "an" or "one" embodiment in this disclosure are not necessarily to the same embodiment, and such references mean at least one.

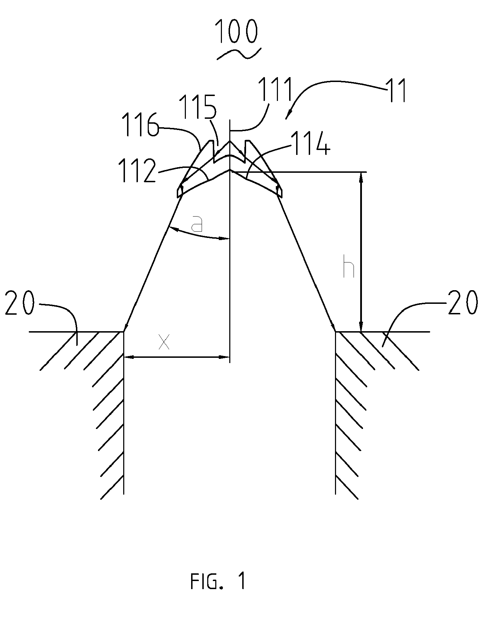

Referring to FIG. 1, an illumination system for LED lamp 100 in accordance with one embodiment of the disclosure is shown. The illumination system for LED lamp 100 includes at least one LED module 10, and at least one illumination area 20 arranged in a lighting direction of the LED module 10. In the present embodiment, the illumination system for LED lamp 100 includes two illumination areas 20. The two illumination areas 20 are respectively mounted on two side of an optical axis of the LED module 10. Understandably, the illumination system for LED lamp 100 may only includes one illumination area 20. The single illumination area 20 must mount on one side of the optical axis of the LED module 10 which locates in the lighting direction thereof. In use, the illumination system for LED lamp 100 may includes a plurality of rows of the LED modules 10. As is well known, each of rows of the LED modules 10 may includes a plurality of LED lamp, which depends on the length or area of the illumination area 20. In the present embodiment, only for explaining and describing the disclosure, one LED module 10 and two illumination areas 20 are shown in figures. As is well known for a person skilled in the art, the illumination system for LED lamp 100 further includes other functional components, such as housing for mounting the LED module 10, cover, power for supplying power for the LED module 10, and so on, which need not to be described in detail.

The LED module 10 includes an LED chip 12, and an LED lens 11 arranged on light path of the LED chip 12.

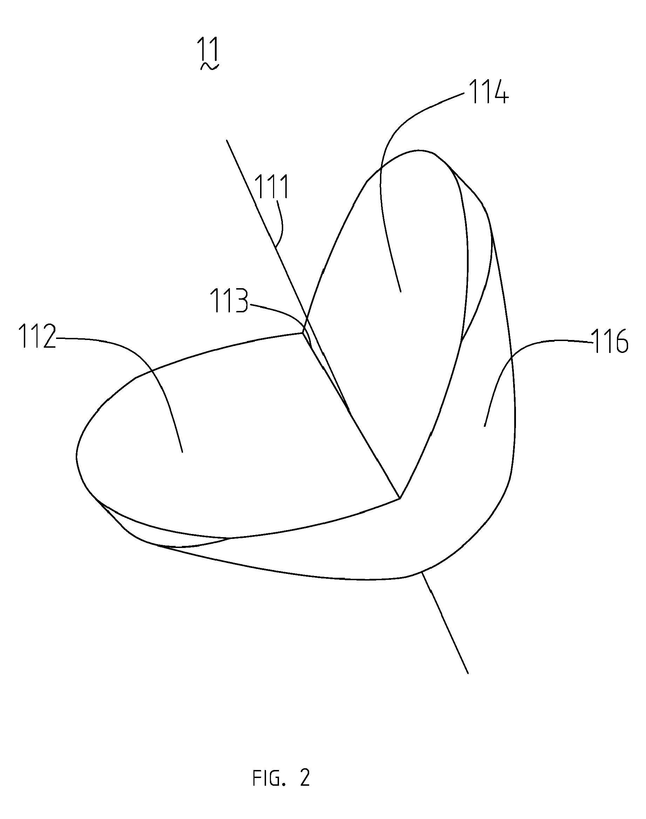

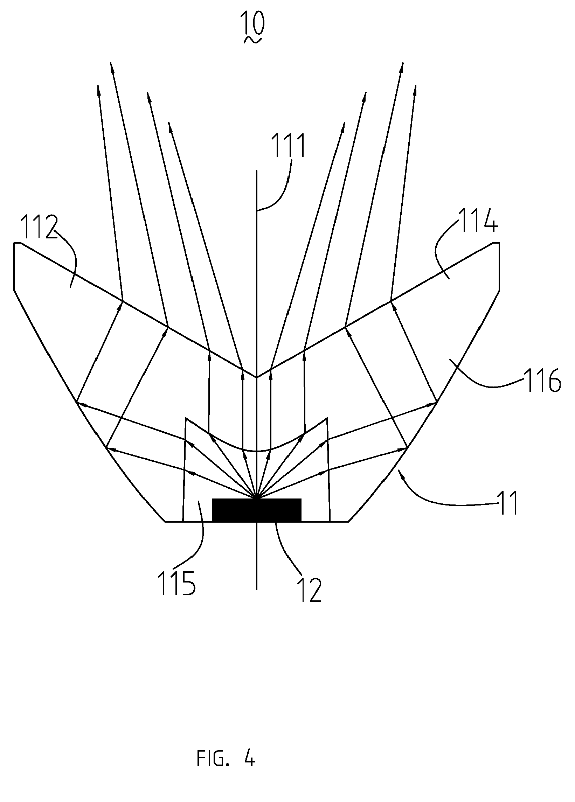

Referring to FIG. 2 to FIG. 5, the LED lens 11 includes an optical axis 111, a first light emitting surface 112, a second light emitting surface 114 which only has one intersecting ling 113 with the first light emitting surface 112, a light source recess 115 arranged through the optical axis 111, and a critical reflection surface 116 disposed between the first, second light emitting surfaces 112, 114 and the light source recess 115.

The optical axis 111 is a universal feature for all of lens and used to dispose the light source, namely the LED chip 12. Moreover, the optical axis 111 is a guide for optic design.

Because the first light emitting surface 112 has same structure, shape, luminous theory, and light path with the second light emitting surface 114, only the first light emitting surface 112 is described in detail as a example. The first, second light emitting surfaces 112, 114 are not at the same level and intersect with each other and only have a intersecting line 113 therebetween. The first, second light emitting surfaces 112, 114 receive the light emitted from the light source recess 115 and the critical reflection surface 116 and directly emitting the received light. That is to say, the first, second light emitting surfaces 112, 114 not distribute the received light, such as reflecting, and directly emit it towards the illumination area 20. In a cross section along a direction perpendicular to the intersecting line 113, the first, second light emitting surfaces 112, 114 form a V-shaped groove. Two sides of the V-shaped groove, namely the first, second light emitting surfaces 112, 114, are symmetrical with the optical axis 111 as the axis of symmetry. As is described above, the two sides of the V-shaped groove receive the light emitted from the light source recess 115 and the critical reflection surface 116 and directly emit it towards the illumination area 20. It is exactly because that the first, second light emitting surfaces 112, 114 or the two sides of the V-shaped groove directly emit the received light, an emergent light of the first light emitting surface 112 is separated from that of the second light emitting surface 114. That is to say, the lights emitted from the first light emitting surface 112 do not intersect with that emitted from the second light emitting surface 14. Similarly, an emergent light of one side of the V-shaped groove is separated from that of another.

The intersecting line 113 is formed between the first light emitting surface 112 and the second light emitting surface 114. In order to control the light path of the first, second light emitting surfaces 112, 114 and make the emergent light of the first, second light emitting surfaces 112, 114 arrange symmetrically, the intersecting line 113 is perpendicular to and intersects with the optical axis 111 so as that the first light emitting surface 112 has same structure, shape, luminous theory, and light path with the second light emitting surface 114.

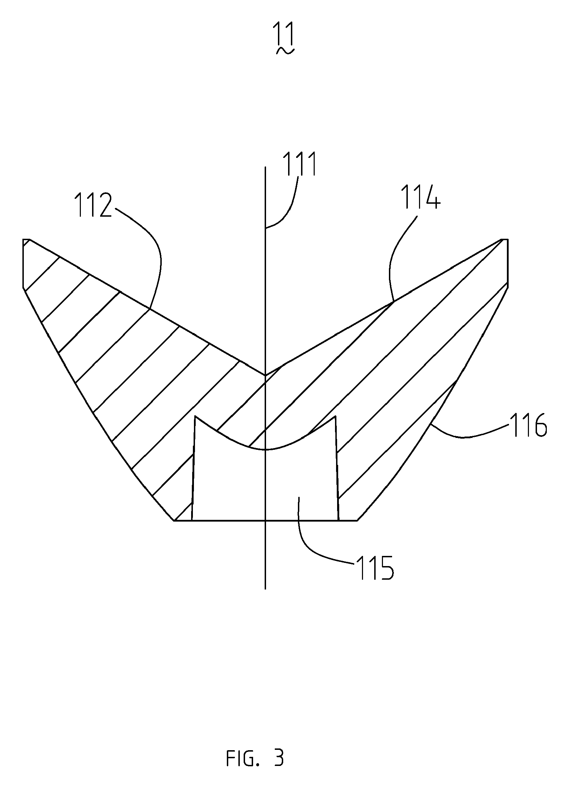

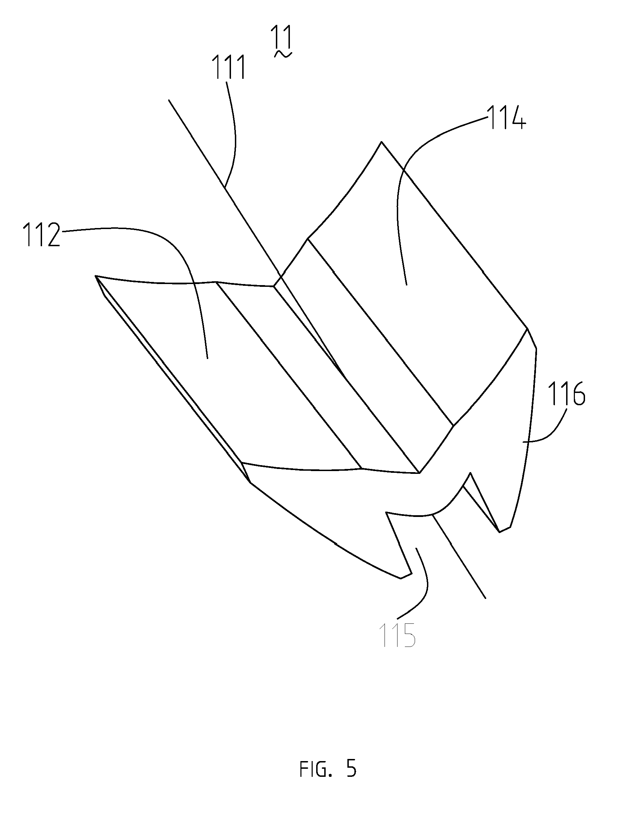

The light source recess 115 is used for mounting the light source, such as the LED chip 12, or other traditional light source. In the present embodiment, the light source is the LED chip 12. When dimension scale between the LED lens 11 and the light source is same as that between the LED lens 11 and the LED chip 12, the light source may be other traditional light source, such as incandescent or fluorescence lighting apparatuses, and so on. The LED chip 12 may be mounted into the light source recess 115 or at outer side of the light source recess 115. When the LED chip 12 is disposed into the light source recess 115, a bottom side of the LED chip 12 is flush with an end of the light source recess 115 for sufficiently taking advantage of the light emitted forward of the LED chip 12 and ease to assemble the LED lens 11 and the LED chip 12. When the LED chip 12 is mounted at outer side of the light source recess 115, a light emitting side of the LED chip 12 is flush with the end of the light source recess 115 for sufficiently taking advantage of the light emitted forward of the LED chip 12. In the present embodiment, the bottom side of the LED chip 12 is flush with the end of the light source recess 115. The light source recess 115 has a different configuration as difference of the whole LED lens 11. As shown in FIG. 3, when the LED lens 11 is a revolution body, that is to say, it is a cone that is centered on the optical axis 111, the light source recess 115 is a hollow cylinder, and the surface intersecting with the optical axis 111 is a convex lens. The convex lens is configured for making the lighting direction therefrom is parallel to the optical axis 111. As shown in FIG. 5, when the LED lens 11 is an elongate body, the light source recess 115 is an elongate slot and the surface intersecting with the optical axis 111 is a convex surface for making the lighting direction therefrom parallel to the optical axis111. The cone or the elongate LED lens can be used in different occasion. For example, the cone LED lens may be used at corner which has little space and the elongate LED lens may be used at large-scale market for assembling a plurality of LED chips 12.

The critical reflection surface 116 is formed an inclined surface like a mortar to receiving the light emitted from the side wall of the light source recess 115 and reflecting the light into the first light emitting surface 112 and the second light emitting surface 114 according to the law of total reflection. In the cross section along the optical axis 111 and a direction perpendicular to the intersecting line 113, one end of a profile of the critical reflection surface 116 connects to the first, second light emitting surfaces 112 and another connects to the free end of the light source recess 115. As a result, the critical reflection surface 116 can receive all of light emitted from the side wall of the light source recess 115. The critical reflection surface 116 has a different configuration as difference of shape of the light source recess 115. When the light source recess 115 is the cylinder, the critical reflection surface 116 is a revolution surface that is centered on the optical axis 111. When the light source recess 115 is the elongate slot, the critical reflection surface 116 is an extension surface which extends along the intersecting line 113 which is perpendicular to the optical axis 112. More preferably, when the critical reflection surface 116 is the extension surface which extends along the intersecting line 113, the first, second light emitting surfaces 112, 114 receive part of the light reflected from the critical reflection surface 116 and have respectively an arc-shaped configuration which is concaved along a direction towards the critical reflection surface 116.

The LED chip 12 is a semiconductor light source and transforms power into light. The LED chip 12 presents many advantages over traditional light sources including lower energy consumption, longer lifetime, improved physical robustness, smaller size, and faster switching. When the light source recess 115 is the hollow cylinder, a center of the LED chip 12 is arranged on the optical axis 111 of the LED lens 11 for ease to optic design. When the light source recess 115 is the elongate slot, the optical axis of the LED chip 12 functions as and regards as one optical axis 111 of the LED lens 11.

Referring to FIG. 1 again, the illuminated area 20 is an object illuminated by the LED module 10 and may be a plan or a curve. In the present embodiment, only for explaining the configuration and principle of the disclosure, the illuminated area 20 is a plan and may be a picture exhibited in museum or selling goods placing in the freezer of supermarket, and so on. In order to obtain perfect lighting affect, the positional relationship between the LED lens 11 and the illumination area 20 is limited in following formula:

$$\text{tga} = x/h$$

 wherein: a is half of beam angle of the LED lens 11;
x is a distance between the illumination area 20 and the optical axis 111 of the LED lens 11;
h is a minimum distance between the illumination area 20 and the LED lens 11.

In above formula, when the LED lens 11 is finished, its beam angle will be a constant. The beam angle means that an angle between two directions in which light intensity is equal to 50% of maximum light intensity of the LED chip 12 in a cross section along the optical axis of the LED chip 12. Therefore, if the distance between the illumination area 20 and the optical axis 111 of the LED lens 11 is X, the minimum distance between the illumination area 20 and the LED lens 11 is h. If the minimum distance between the illumination area 20 and the LED lens 11 is less than h, part of the illumination area 20 cannot be illuminated. And if the minimum distance between the illumination area 20 and the LED lens 11 is greater than h, part of light emitted from the LED lens 11 may be wasted. Since the emergent light of the first light emitting surface 112 is separated from that of the second light emitting surface 114, the two illumination area 20 should be respectively mounted in two symmetric sides of the intersecting line 113 of the first, second light emitting surface 112, 115 or an intersecting line of the V-shaped groove.

In use, since the LED lens 11 has the first, second light emitting surfaces 112, 114 and the emergent light of the first light emitting surface 112 is separated from that of the second light emitting surface 114, the light emitted from the first, second light emitting surfaces 112, 114 illuminate towards the direction which is far away from the optical axis 111. Moreover, when people browse the goods on the storage rack, they will locate in a non-illumination area, such as aisle, in which it has no light. Therefore, the illumination system for LED lamp 100 not only light up two rows of goods but also it has no light glaring people's eyes.

While the present invention has been described by way of example and in terms of exemplary embodiment, it is to be understood that the disclosure is not limited thereto. To the contrary, it is intended to cover various modifications and similar arrangements (as would be apparent to those skilled in the art. Therefore, the scope of the appended claims should be accorded the broadest interpretation so as to encompass all such modifications and similar arrangements.

**Claims**

1. An LED lens comprising an optical axis (111), a first light emitting surface (112), a second light emitting surface (114) which only has one intersecting line (113) with the first light emitting surface (112), a light source recess (115) arranged through the optical axis (111), and a critical reflection surface (116) disposed between the first, second light emitting surfaces (112, 114) and the light source recess (115), the intersecting line (113) being perpendicularly intersect with the optical axis (111), the first, second light emitting surfaces (112, 114) receiving the light emitted from the light source recess (115) and the critical reflection surface (116) and directly emitting the receiving light, an emergent light of the first light emitting surface (112) being separated from that of the second light emitting surface (114).

2. The LED lens of claim 1, wherein the critical reflection surface (116) is a revolution surface that is centered on the optical axis (111).

3. The LED lens of claim 2, wherein the light source recess (115) is a cylinder, the surface intersecting with the optical axis (111) is a convex lens, the convex lens is configured for making the lighting direction therefrom is parallel to the optical axis (111).

4. The LED lens of claim 1, wherein the light source recess (115) is an extension groove, the surface intersecting with the optical axis (111) is a convex surface, the convex surface is configured for making the lighting direction therefrom is parallel to the optical axis (111).

5. The LED lens of claim 4, wherein the critical reflection surface (116) is an extension surface which extends along a line perpendicular to the optical axis (111), the first, second light emitting surfaces (112, 114) receive part of light reflected from the critical reflection surface (116) and have an arc-shaped configuration which is concaved along a direction toward the critical reflection surface (116).

6. A LED lens comprising an optical axis (111), a V-shaped groove, a light source recess (113) arranged through the optical axis (111), and a critical reflection surface (116) arranged between the V-shaped groove and the light source recess (115), two sides of the V-shaped groove being symmetrical with the optical axis (111) as the axis of symmetry, the two sides of the V-shaped groove receiving the light emitted from the light source recess (115) and the critical reflection surface (116) and directly emitting the received light, an emergent light of one side of the V-shaped groove being separated from that of another.

7. The LED lends of claim 6, wherein the critical reflection surface (116) is an extension surface which extends along a line perpendicular to the optical axis (111).

8. An illumination system for LED lamp comprising at least one LED lens (10) claimed in claim from 1 to 7, and at least one illumination area (20) arranged in lighting direction of the LED lens (10), the positional relationship between the LED lens (10) and the illumination area (20) be limited in following formula:

$$\mathrm{tga} = \mathrm{x/h}$$

wherein: a is half of beam angle of the LED lens (10); x is a distance between the illumination area (20) and the optical axis (111) of the LED lens (10); h is a minimum distance between the illumination area (20) and the LED lens (10).

9. The illumination system for LED lamp of claim 7, wherein the illumination system for LED lamp (100) comprises two illumination areas (20) arranged in lighting direction of the LED lens (10), the two illumination areas (20) are mounted in two symmetric sides of the intersection line (113) of the first, second light emitting surfaces (112, 114).

10. The illumination system for LED lamp of claim 7, wherein the illumination system for LED lamp (100) comprises two illumination areas (20) arranged in lighting direction of the LED lens (10), the two illumination areas (20) are mounted in two symmetric sides of an intersection line (113) of the V-shaped groove.

FIG. 1

11

114

111

113

112

116

FIG. 2

FIG. 3

FIG. 4

FIG. 5

**Europäisches Patentamt**

**European Patent Office**

**Office européen des brevets**

## EUROPEAN SEARCH REPORT

**Application Number**

EP 14 19 9088

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 708 806 A1 (LIN WANJIONG [CN]) 19 March 2014 (2014-03-19) * paragraphs [0023],[0024],[0030],[0031]; figures 4A,7 * | 1-10 | INV. G02B27/09 F21V5/04 F21V7/00 H01L33/54 |
| X | EP 2 287 653 A1 (PANASONIC ELEC WORKS CO LTD [JP]) 23 February 2011 (2011-02-23) * figures 4-7 * * figures 12,13 * | 1-10 | H01L33/58 G02B19/00 |
| X | US 2010/296283 A1 (TASKAR NIKHIL [US] ET AL) 25 November 2010 (2010-11-25) * paragraph [0042] - paragraph [0043]; figures 15,16 * | 1-10 | |

TECHNICAL FIELDS SEARCHED (IPC)

G02B
F21V
H01L

The present search report has been drawn up for all claims

| Place of search | Date of completion of the search | Examiner |
|---|---|---|
| Munich | 25 September 2015 | Muller, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 14 19 9088

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2015

| Patent document cited in search report | | Publication date | Patent family member(s) | | Publication date |
|---|---|---|---|---|---|
| EP 2708806 | A1 | 19-03-2014 | CN | 103672730 A | 26-03-2014 |
| | | | EP | 2708806 A1 | 19-03-2014 |
| | | | US | 2014071693 A1 | 13-03-2014 |
| EP 2287653 | A1 | 23-02-2011 | CN | 101994989 A | 30-03-2011 |
| | | | EP | 2287653 A1 | 23-02-2011 |
| | | | JP | 2011044315 A | 03-03-2011 |
| US 2010296283 | A1 | 25-11-2010 | CA | 2761679 A1 | 25-11-2010 |
| | | | EP | 2433046 A2 | 28-03-2012 |
| | | | US | 2010296283 A1 | 25-11-2010 |
| | | | US | 2013250573 A1 | 26-09-2013 |
| | | | WO | 2010135113 A2 | 25-11-2010 |

EPO FORM P0459

For more details about this annex : see Official Journal of the European Patent Office, No. 12/82

**EP 2 950 134 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201410240806